# EUROPEAN PATENT APPLICATION

(11) **EP 4 637 278 A1**
(43) Date of publication of application: **22.10.2025**
(21) Application number: 24170587.0
(22) Date of filing: 16.04.2024
(51) Int. Cl.: H05K 3/28, H05K 3/22

(54) **METHOD OF DISMANTLING ELECTRONIC STACK**

(71) Applicant: Nederlandse Organisatie voor toegepast-natuurwetenschappelijk Onderzoek TNO, 2595 DA 's-Gravenhage (NL)
(72) Inventor: HARKEMA, Stephan, 2595 DA's-Gravenhage (NL)
(74) Representative: V.O.

(57) **Abstract**

A method of dismantling an electronic stack (10). The electronic stack (10) comprises a set of electronics (13) encapsulated between a first layer (11) and a second layer (12) and separated from the first and/or second layer (11,12) by a delamination layer (14). The electronic stack (10) further comprises an edge layer (15) formed of a trigger-sensitive edge material (M15) extending over an edge area (Ae) between an edge (14e) of the delamination layer (14) and an edge (10e) of the electronic stack (10). A trigger (T) is applied to the edge layer (15) causing degradation of the trigger-sensitive edge material (M15), thereby at least partially separating the first layer (11) from the second layer (12) and forming an exposed flap (16) to be gripped (G) to further pull apart the first and second layers (11,12). The pulling apart (P) may be further facilitated by the delamination layer (14).

## Description

### TECHNICAL FIELD AND BACKGROUND

The present disclosure relates to methods and system for dismantling electronic stacks, and electronic stacks made suitable for dismantlement.

In recent years, there has been a notable trend in electronic design that emphasizes seamless and tight integration, compact form factors, waterproof designs, and the innovative use of touch-and-feel thermoformed plastic encapsulation. This trend is driven by the desire to create sleek, rugged, and aesthetically pleasing electronic devices that offer enhanced user experiences and improved functionality. However, these advanced electronic devices pose significant challenges to traditional recycling processes. The tight integration of electronics into enclosures with smooth and curved edges makes it difficult for recycling facilities to efficiently access and disassemble the components, as these modern, sleek designs do not allow for the placement of screws or grips typically used for disassembly. The small size, intricate designs, and encapsulation of electronic elements hinder traditional recycling methods, potentially leading to increased e-waste and environmental impact. There is a need to develop new disassembly methods for recycling modern electronic devices in order to limit the environmental impact of electronic waste.

There is a need to mitigate the disadvantages of the prior art while retaining at least some of its advantages. In particular, there is a need to further facilitate the disassembly of electronic stacks and devices.

### SUMMARY

By way of background, WO 2022 / 220688 A2 discloses manufacturing methods for producing an electronic device that is more easily recyclable, e.g. separable into component parts at the end of life. Typically, an electronic device may comprise a stack of layers including a set of electronics disposed between the layers and/or forming one of the layers. To facilitate separation, one or more delamination layers can be provided as part of the stack to cover at least one side of the electronics, preferably both sides. For example, an encapsulation layer can be applied on top of the at least one delamination layer to encapsulate both the electronics and the one or more delamination layers therebetween. In this arrangement, the one or more delamination layers may keep the electronic components separate from the encapsulation layer and/or other layers of the stack, e.g. (first) substrate on the opposite side of the electronics relative to the encapsulation layer.

Delamination is a process wherein a material or object, in this case the stack, can be separated into layers. This may also be referred to as debonding. As will be appreciated, applying one or more delamination layers to one or both sides of the electronics, may allow relatively easy separation of the electronic components from the substrate and/or encapsulation layer during a later recycling process (after the device end of use). Accordingly, components and/or circuit parts can be more easily separated from the set of electronics without being covered by (stuck to) the substrate or encapsulation layer. This may improve recyclability of the device. By covering both sides of the electronics with a respective delamination layer, the components may be easily separated from both the substrate and encapsulation layer. So the components can be completely isolated during a later recycling process.

To facilitate access to the delamination layer, WO 2022 / 220688 A2 discloses the presence of a fluid inlet formed by an open passage extending from an exterior of the encapsulation layer to one or more delamination layers. Fluid injected into the fluid inlet is then used to dissolve or disintegrate the one or more delamination layers. However, the presence of inlets may not be desired in the case of seamlessly integrated waterproof electronic devices encapsulated in a sleek plastic cover such as a thermoformed cover with smooth surface and rounded edges.

The present invention aims at improving the recycling of electronic devices, e.g. an electronic stack, without the need for fluid injection passages. The electronic stack comprises a set of electronics encapsulated between a first layer and a second layer. The set of electronics is separated from at least one of the first layer and second layer by a delamination layer. The delamination layer is formed of a delamination material to facilitate separation of the set of electronics from at least one of the first and second layers. The delamination layer is fully encapsulated within the electronic stack to prevent inadvertent delamination of the electronic stack during a product lifetime of the electronic stack.

Advantageously, by providing the electronic stack with an edge layer formed of a trigger-sensitive edge material, trigger can be applied to the edge layer to cause degradation of the trigger-sensitive edge material to at least partially separate the first layer from the second layer at the edge area of the electronic stack. Preferably, the trigger-sensitive material extends across an edge area between an edge of the delamination layer and an edge and/or outer portion of the electronic stack so that the at least partially separated first and second layers can form an exposed flap. By forming an exposed flap, smooth edges of tightly integrated electronics can be easily gripped on. By gripping on to the exposed flap, the first and second layers can be pulled further apart. As will be appreciated, the pulling apart is facilitated by the delamination layer between the first and second layers.

By arranging the trigger-sensitive edge material in direct contact with the delamination material, inadvertent tearing of the first and/or second layer at the edge of the delamination layer during dismantling can be prevented. By providing a thin boundary of the first and/or second layer material between the trigger-sensitive edge material and the delamination material, the two materials can be kept separate from each other and inadvertent delamination of the first and second layer at the edge of the delamination layer can be prevented during product life time.

By forming the edge layer of a material having a higher adhesive strength to the first and second layers compared to the delamination layer material, strong bonding at the edges and weak bonding at the inside of the electronic device can be achieved. For example, the electronic device will resist tearing at the edges during the product lifetime, but will be relatively easy to dismantle for recycling of its internal components.

By providing the electronic stack with an edge layer having a relatively small volume compared to the delamination layer, and by forming the edge layer from a material soluble in a non-aqueous solvent and the (encapsulated) delamination layer of a material soluble in water, the waterproofness of the electronic stack can be maintained, yet the electronic stack can be conveniently dismantled using a rather low amount of the specific non-aqueous solvent and a relatively large amount of water.

By arranging the trigger-sensitive edge material flush adjacent to the delamination material, the integrity of the first and second layers can be maintained during dismantling. By providing the trigger-sensitive edge material above or below the delamination layer, the first and/or second layers can be broken open during the dismantling.

By forming the trigger-sensitive edge material and delamination material from materials having at least one different property after application of the same trigger, the two dismantling processes can be divided into at least two steps. For example, the first step may comprise exposing a flap upon application of the trigger and the second step can comprises grasping and pulling on the flap to separate the first and second layers apart. Advantageously, the edge and delamination materials can have different adhesion properties to the first and/or second layer in the absence of the trigger. For example, the trigger-sensitive edge material may have strong adhesive force and the delamination material may have a weak adhesive force to the first and/or second layer.

By arranging the edge layer in a corner, the exposed flap can be uniquely identified and the first and second layers can be conveniently pulled apart. For example, the edge layer may be arranged in a corner of a rectangular electronic stack. Alternatively, or in addition, the edge layer can be arranged along a circumference of a cylindrical electronic stack.

By arranging the trigger-sensitive edge material in a pattern, flaps of advanced shapes and/or a set of flaps can be exposed during the dismantling process. Preferably, the trigger-sensitive edge material is arranged in a simple geometric pattern such as a trapezoidal and/or cylindrical shape. Alternatively, or in addition, more advanced patterns can be realized, e.g. by 3-D printing.

By arranging the edge layer adjacent to interconnects, flexible printed-circuit boards and/or other unique features of the electronic stack, the location of the edge layer for applying the trigger can be quickly identified. For example, the edge layer can be arranged adjacent a flexible interconnect that protrudes from the electronic stack. The location of the flexible interconnect can be readily identified during recycling, and the trigger can be subsequently applied to the edge layer adjacent the flexible interconnect.

Other aspects relate to a recyclable electronic stack and/or a system for recycling the electronic stack. For example, the electronic stack is manufactured for convenient recycling using the dismantling method and system described herein.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A-1D illustrate dismantling of an electronic stack from a sideview;
FIGs 2A-2C illustrate dismantling of an electronic stack from a top-down perspective;
FIG 3A illustrates pulling an electronic stack apart; and
FIG 3B illustrates a system for dismantling an electronic stack.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

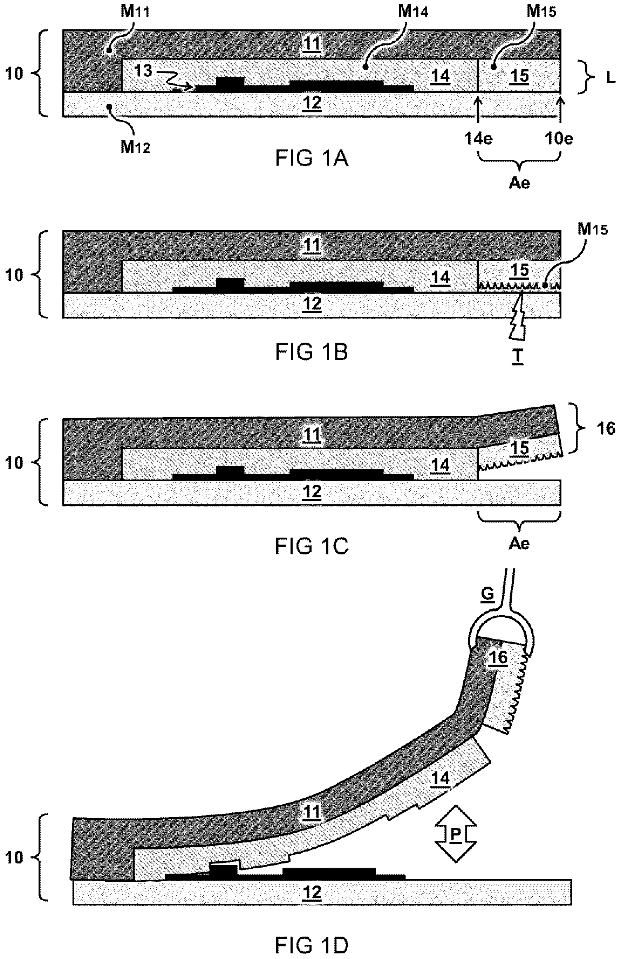

FIGs 1A-D illustrate a method of dismantling an electronic stack 10 comprising a set of electronics 13 encapsulated between a first layer 11 and a second layer 12. In some embodiments, e.g. as shown in FIG 1A, the set of electronics 13 is separated from at least one of the first layer 11 and second layer 12 by a delamination layer 14. In one embodiment, the delamination layer 14 is formed of a delamination material M14 to facilitate separation of the set of electronics 13 from the first and/or second layers 11,12. In another or further embodiment, the delamination layer 14 is fully encapsulated within the electronic stack 10 to prevent inadvertent delamination of the electronic stack 10 during a product lifetime of the electronic stack 10. In yet another or further embodiment, the electronic stack 10 comprises an edge layer 15 formed of a trigger-sensitive edge material M15 extending over an edge area Ae between an edge 14e of the delamination layer 14 and an edge 10e of the electronic stack 10.

Preferably, the trigger-sensitive edge material M15 is directly connected to the delamination material M14. Alternatively, or in addition, a thin boundary of another material, e.g. the first and/or second layer material M11,M12, is provided between the trigger-sensitive edge material M15 and the delamination material M14.

In some embodiments, e.g. as shown in FIG 1B, the method of dismantling the electronic stack comprises applying a trigger T to the edge layer 15 to cause degradation of the trigger-sensitive edge material M15. In one embodiment, the degradation causes the first layer 11 to at least partially separate from the second layer 12 at the edge area Ae of the electronic stack 10. In another or further embodiment, e.g. as shown in FIG 1C, the partially separated first and second layers 11,12 form an exposed flap 16.

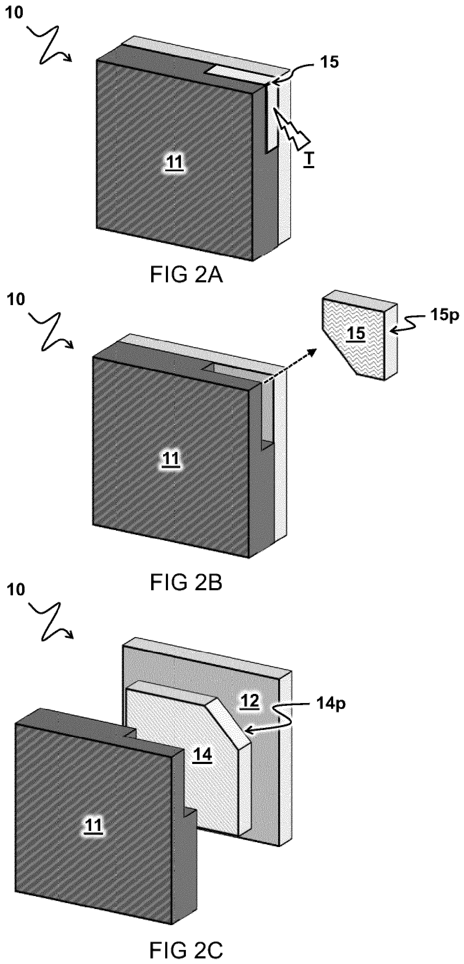

Preferably, the trigger T is applied to the edge layer 15 to directly reach the trigger-sensitive edge material M15, e.g. as shown in FIGs 2A-3A. Alternatively, or in addition, the trigger T can be applied through at least one of the first and second layers 11,12, e.g. as shown in FIG 1B.

In other or further embodiments, e.g. as shown in FIG 1D, the method of dismantling the electronic stack comprises gripping G on to the exposed flap 16 to pull the first and second layers 11,12 further apart. In one embodiment, the pulling apart P is facilitated by the delamination layer 14 between the first and second layers 11,12.

In some embodiments, the delamination layer 14 is separable from the first layer 11 and/or the second layer 12 by a delamination material M14 that is dissolvable and/or disintegrable by a solvent, preferably a non-toxic solvent. Preferably, the solubility is more than 0.1 gram per 100 milliliters of solvent, more preferably ≥ 1 g / 100 mL, ≥ 10 g / 100 mL, ≥ 100 g / 100mL, or fully miscible without limit. The higher the solubility, the more easily the delamination layer material can be dissolved. In another or further embodiment, the delamination material M14 is soluble in water. For example, the delamination layer material is based on aqueous polymers. In another of further example, the delamination layer is configured to form a lacquer between the respective layers.

In other or further embodiments, the solubility of the delamination material M14 in a respective solvent such as water is higher than the solubility of the first and/or second layer materials M11,M12 in the respective solvent, e.g. higher by at least a factor ten, fifty, hundred or more. Most preferably, the first and second layer materials M11,M12 are essentially insoluble in the respective solvent, e.g. insoluble in water. The more insoluble the first and second layer materials M11,M12, the better the structural integrity can be maintained during normal use.

In some embodiments, the first layer 11 is separable from the second layer 12 by the delamination material M14 having a relatively low melting point, liquefaction/softening temperature and/or glass transition temperature compared to first and second layer material M11,M12, e.g. at least ten, twenty, fifty, or hundred degrees Celsius lower and/or in absolute sense preferably less than 200 °C, or even less than 150 °C. For example, the first and second layer materials M11,M12 may have relatively high melting point, liquefaction/softening temperature and/or glass transition temperature so that it does not soften during normal use, e.g. remains solid at least up to one hundred degrees Celsius, preferably at least up to 200 °C or 250 °C.

In some embodiments, the first layer 11 is separable from the second layer 12 by the delamination material M14 having a relatively weak adhesive force per surface area to the first layer 11, the second layer 12, and/or the set of electronics 13 - at least compared to a relatively strong adhesive force between the first layer 11 and the second layer 12 without a delamination layer therebetween, e.g. lower in Newton per square meter by at least a factor of two, three, five, ten or more. Other types of separation may also be contemplated.

In one embodiment, the aforementioned relatively weak adhesive force of any of the layers to the delamination layer 14 is less than twenty Newton per centimeter, preferably less than fifteen Newton per square centimeter, more preferably less than ten N/cm, most preferably less than five N/cm. Optionally, the delamination layer 14 may be further supported and/or spontaneous delamination may be prevented by adding one or more connections, e.g. pillars, extending through the delamination layer, such as disclosed in WO 2022/220688 A2. In another or further embodiment, the aforementioned relatively strong adhesive force between the first and second layers 11,12, without the delamination layer 14 therebetween, is more than five Newton per centimeter, preferably more than 10 N/cm, or even ≥twenty N/cm. In particular, the relatively strong adhesive force may exceed the structural integrity of the materials/layers, e.g. the layers may be torn when trying to separate them. In general, the adhesive strength between layers can be measured in various ways. For example, the aforementioned values of adhesive strength can be measured using a 90° peel test peel test at 100 mm/min as described by the ISO 8510-1:2022 standard (standard test temperature 23 ± 2 °C and relative humidity 50 ± 5%).

In other or further embodiments, the edge layer 15 comprises or essentially consists of a trigger-sensitive edge material M15, different from the delamination material M14. In some embodiments, the adhesive strength of the trigger-sensitive edge material M15 to the first and second layers 11,12 is at least a factor of two, five, preferably ten higher than to the adhesive strength of the delamination material M14.

In some embodiments, the trigger-sensitive edge material M15 has different sensitivity to solvents than the delamination material M14. For example, the trigger-sensitive edge material M15 is soluble in a particular solvent, in which the delamination material M14 is insoluble and/or sparingly soluble.

In some embodiments, the trigger-sensitive edge material M15 can be debonded on demand by pressure-sensitive adhesives, e.g. photo-reversible cross-linking materials or expandable fillers. In other or further embodiments, the delamination material M14 and the trigger-sensitive edge material M15 degrade at different rates over time when exposed to the same (external) trigger.

Preferably, the trigger-sensitive edge material M15 and the delamination material M14 are arranged flush, adjacent each other, to form a uniformly oriented layer L sandwiched between the first and second layers 11,12. Alternatively, or in addition, the trigger-sensitive edge material M15 and the delamination material M14 may be partially interleaved.

During normal use, e.g. in the absence of the trigger T, the trigger-sensitive edge material M15 is configured to protect the encapsulated delamination layer 14 from external conditions, e.g. moisture and/or heat, acting on the electronic stack 10.

In one embodiment, the trigger-sensitive edge material M15 has a solubility in a respective solvent that is lower than the solubility of the encapsulated delamination material M14, but higher than the first and second layer materials M11,M12. Preferably, to prevent degradation of the electronic stack 10 during normal use, the trigger-sensitive edge material M15 is insoluble in water. More preferably, to facilitate dismantling of the electronic stack 10, the delamination material M14 is water soluble.

In another or further embodiment, the trigger-sensitive edge material M15 has a relatively high melting point, liquefaction/softening temperature and/or glass transition temperature compared to the delamination material M14, but relatively low as compared to the first and second layer materials M11,M12.

In yet other or further embodiment, the trigger-sensitive edge material M15 has a relatively weak adhesive force per surface area to the first and second layer 11,12 compared to a relatively strong adhesive force between the first layer 11 and second layer 12. Preferably, there is essentially no adhesion of the trigger-sensitive edge material M15 to the first layer 11 and/or second layer 12 after application of the trigger T. During recycling of the electronic stack, e.g. dismantling, the trigger-sensitive edge material M15 is configured upon application of the trigger to provide an access point, e.g. an exposed flap, for pulling apart the first and second layers.

In some embodiments, the trigger-sensitive edge material M15 and the delamination material M14 differ in by at least one of solubility, melting point, and adhesive force. In one embodiment, the trigger-sensitive edge material M15 has a higher solubility than the delamination material M14 in a solvent used as the trigger T. In another or further embodiment, the trigger-sensitive edge material M15 has a lower melting point for heat applied as the trigger T than the delamination material M14. In another or further embodiment, the trigger-sensitive edge material M15 has a lower adhesive force to the first layer 11 and/or the second layer 12 than the delamination material M14 e.g. after applying the same trigger T to both materials M14,M15. For example, the trigger T may be solvent, heat, or force.

FIGs 2A-C illustrate dismantling of an electronic stack from a top-down perspective. As shown in FIG 2A, the edge layer 15 can form part of a corner and/or a curved edge of the electronic stack 10. For example, the edge layer 15 can form one or more corners of a cubic electronic stack 10. Alternatively, or in addition, the edge layer 15 can form a perimeter of a cylindrical electronic stack 10.

As shown in FIGs 2B-C, the trigger-sensitive edge material M15 can be disposed in an edge pattern 15p and the delamination material M14 can be disposed in a delamination pattern 14p complementary to the edge pattern 15p. Preferably, the trigger-sensitive edge material M15 is arranged in a simple geometric pattern such as a trapezoidal and/or cylindrical shape. In one embodiment, the edge pattern 15p forms a trapezoidal shape and the delamination pattern 14p forms at least partially complementary trapezoidal shape that fills the inner area of a rectangular and/or cuboidal electronic stack 10. Alternatively, or in addition, the edge pattern 15p forms at least a portion of a hollow cylinder and the delamination pattern 14p forms at least partially complementary cylindrical shape filling in the inner area of a cylindrical electronic stack 10. Other or further complementary shapes and/or patterns may be contemplated. In some embodiments, the edge pattern 15p and delamination pattern 14p are printed patterns, e.g. 3-D printed patterns. In other or further embodiments, the edge pattern 15p and the delamination pattern 14p are arranged between the first layer 11 and the second layer 12 with no electronics therebetween.

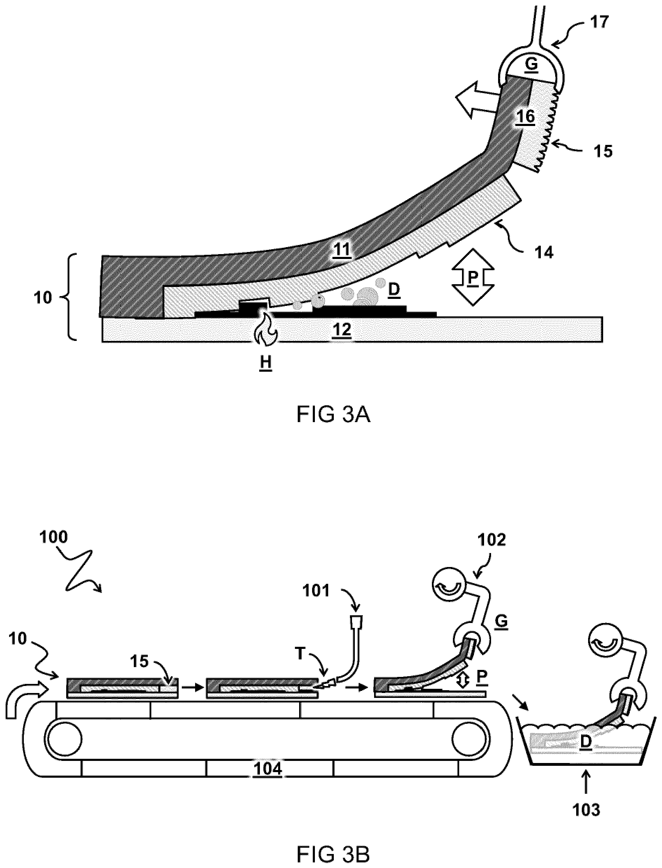

FIGs 3A illustrates the pulling apart of an electronic stack. In one embodiment, after at least partially degrading the trigger-sensitive edge material M15, the bonding strength of the delamination layer 14 to the first and/or second layer 11,12 is weakened by disintegrating, dissolving, and/or melting the delamination material M14, e.g. to further facilitate the pulling apart P of the first and second layers 11,12. For example, the trigger-sensitive edge material M15 is degraded using light, e.g. photonic debonding, and the delamination material M14 is dissolved by immersing the at least partially exposed delamination layer 14 in water. Alternatively, or in addition, heat H may be applied to the partially exposed delamination layer, e.g. to accelerate the dissolution.

In some embodiments, gripping G on to the exposed flap 16 comprises attaching a clamp 17 to the exposed flap 16. In one embodiment, the clamp is attached using mechanical, suction, adhesive, and/or magnetic forces. For example, the clamp 17 comprises a robotic gripper configured to grip the exposed flap 16 to pull the first layer 11 apart from the second layer 12 while the second layer 12 is held in place, e.g. by a vacuum suction pump.

In other or further embodiments, the trigger-sensitive edge material M15 of the edge layer 15 is formed by a hot melt and/or reversible adhesive. For example, the hot melt comprises Thermoplastic Polyurethane (TPU) hot melt and the reversible adhesive comprises a Diels-Alder reversible adhesive based on acrylate, TPUs and/or epoxy.

In still other or further embodiments, the edge layer 15 and the delamination layer 14 are used to dismantle an injection molded and/or thermoformed part from an electronic stack 10. In one embodiment, the thermoformed part is a decorative part with smooth edges. For example, the thermoformed part provides a unique design to an electronic device comprising the electronic stack 10. In other or further embodiment, the thermoformed part is a functional part of an electronic device comprising the electronic stack 10. For example, the thermoformed part may function as a light diffuser and/or a lens for a light of a light-emitting diode.

In some embodiments, the edge layer 15 is arranged adjacent to interconnects and/or flexible printed-circuit boards used for external contacting of electronic components encapsulated in the thermoformed part of the electronic stack 10.

In another or further embodiments, the electronic stack 10 comprises an internal heat generation circuit, e.g. a printed circuit, disposed at the edge area Ae for dissipating heat to a trigger-sensitive edge material M15 prior to exposing the flap 16. In one embodiment, the internal heat generation circuit is a resistive circuit configured to dissipate heat when activated. In another or further embodiment, the trigger-sensitive edge material M15 is a heat-sensitive material that configured to weaken and/or disintegrate when exposed to the heat dissipated by the resistive circuit. In another or further embodiment, the printed circuit is pre-programmed and/or remotely controlled to initiate internal heat generation at the end of product life time.

In some embodiments, the electronic stack 10 is manufactured by encapsulating a set of electronics 13 between a first layer 11 and a second layer 12. In one embodiment, the set of electronics 13 is separated from at least one of the first layer 11 and second layer 12 by a delamination layer 14. In another or further embodiment, the delamination layer 14 is formed of a delamination material M14 to facilitate separation of the set of electronics 13 from the first and/or second layers 11,12. In another or further embodiment, the delamination layer 14 is fully encapsulated within the electronic stack 10 for preventing inadvertent delamination of the electronic stack 10 during a product lifetime of the electronic stack 10.

In other or further embodiments, the method of manufacturing the electronic stack 10 further comprises applying, to the electronic stack 10, an edge layer 15 formed of a trigger-sensitive edge material M15 extending over an edge area Ae between an edge 14e of the delamination layer 14 and an edge 10e of the electronic stack 10.

FIG 3B illustrates a system 100 for dismantling an electronic stack 10 manufactured according to the method described herein. In one embodiment, the system 100 comprises a trigger applicator 101 configured to apply a trigger T, e.g. heat, solvent, force, to the edge layer 15 of the electronic stack 10 to cause degradation of the trigger-sensitive edge material M15 and thereby forming an exposed flap 16. In another or further embodiment, the system 100 comprises a separator 102 configured to engage with the exposed flap 16 to pull the first and second layers 11,12 further apart. In another or further embodiment, the pulling apart P is facilitated by the delamination layer 14 between the first and second layers 11,12.

In some embodiments, the system 100 comprises means for reading, from the electronic stack 10, the type of trigger T for the trigger-sensitive edge material M15, the solvent for the delamination material M14, and/or the location of the edge layer 15 within the electronic stack 10. For example, the system 100 comprises a camera and a processor configured to read and interpret recycling and/or dismantling instructions encoded in a QR code disposed on the electronic stack 10. In another or further embodiment, the system 100 further comprises a dissolving station 103 for dissolving D the delamination layer 14, thereby further facilitating the pulling apart P of the first and second layers 11,12.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope.

## Claims

1. A method of dismantling an electronic stack (10), the electronic stack (10) comprising a set of electronics (13) encapsulated between a first layer (11) and a second layer (12), wherein the set of electronics (13) is separated by a delamination layer (14) from at least one of the first layer (11) and second layer (12), wherein the delamination layer (14) is formed of a delamination material (M14) for facilitating separation of the first and/or second layers (11,12) from the set of electronic (13) during the dismantling, wherein the delamination layer (14) is fully encapsulated within the electronic stack (10) for preventing inadvertent delamination of the electronic stack (10) during a product lifetime of the electronic stack (10), wherein the electronic stack (10) comprises an edge layer (15) formed of a trigger-sensitive edge material (M15) extending over an edge area (Ae) between an edge (14e) of the delamination layer (14) and an edge (10e) of the electronic stack (10), the method comprising
applying a trigger (T) to the edge layer (15) causing degradation of the trigger-sensitive edge material (M15), wherein the degradation causes the first layer (11) to at least partially separate from the second layer (12) at the edge area (Ae) of the electronic stack (10), wherein the at least partially separated first and second layers (11,12) form an exposed flap (16) at the edge area (Ae); and
gripping (G) on to the exposed flap (16) to pull the first and second layers (11,12) further apart, wherein the pulling apart (P) is facilitated by the delamination layer (14) between the first and second layers (11,12).

2. The method according to the preceding claim, wherein the trigger-sensitive edge material (M15) and the delamination material (M14) are arranged flush, adjacent each other, to form a continuous layer (L) sandwiched between the first and second layers (11,12).

3. The method according to any of the preceding claims, wherein the trigger-sensitive edge material (M15) the delamination material (M14) are arranged in complementary patterns (14p,15p) to form a single layer of the electronic stack (10).

4. The method according to any of the preceding claims, wherein the edge layer (15) is arranged at a corner and/or a curved edge of the electronic stack (10).

5. The method according to any of the preceding claims, wherein said gripping (G) on to the exposed flap (16) comprises attaching a clamp (17) to the exposed flap (16).

6. The method according to any of the preceding claims, wherein the trigger-sensitive edge material (M15) and the delamination material (M14) differ by at least one of
the trigger-sensitive edge material (M15) having a higher solubility than the delamination material (M14) in a solvent used as the trigger (T);
the trigger-sensitive edge material (M15) having a lower melting point than the delamination material (M14) for heat applied as the trigger (T);
the trigger-sensitive edge material (M15) exhibiting a lower adhesive force to the first layer (11) and/or second layer (12) than the delamination material (M14) after application of the trigger (T).

7. The method according to any of the preceding claims, wherein the trigger-sensitive edge material (M15) of the edge layer (15) is formed by a hot melt and/or reversible adhesive.

8. The method according to any of the preceding claims, wherein subsequent to at least partially degrading the trigger-sensitive edge material (M15) a bonding strength of the delamination layer (14) to the first and/or second layer (11,12) is weakened by disintegrating, dissolving, and/or melting of the delamination material (M14) for facilitating the pulling (P) of the first and second layers (11,12) further apart.

9. The method according to any of the preceding claims, wherein the electronic stack (10) comprises an internal heat generation circuit disposed at the edge area (Ae) for dissipating heat to a trigger-sensitive edge material (M15) prior to exposing the flap (16).

10. The method according to the preceding claim, wherein the internal heat generation circuit is pre-programmed and/or remotely controlled to initiate internal heat generation at the end of product life time.

11. The method according to any of the preceding claims, wherein at least one of the first and second layers (11,12) is formed by injection molding, lamination and/or thermoforming.

12. The method according to the preceding claim, wherein the edge layer (15) is arranged adjacent to interconnects and/or flexible printed-circuit boards used for external contacting of electronic components encapsulated in an injection molded and/or thermoformed part of the electronic stack (10).

13. An electronic stack (10), manufactured to be dismantled according to the method of any of the preceding claims, the electronic stack (10) comprising a set of electronics (13) encapsulated between a first layer (11) and a second layer (12), wherein the set of electronics (13) is separated by a delamination layer (14) from at least one of the first layer (11) and second layer (12), wherein the delamination layer (14) is formed of a delamination material (M14) for facilitating separation of the first and/or second layers (11,12) from the set of electronic (13) during dismantling of the electronic stack (10), wherein the delamination layer (14) is fully encapsulated within the electronic stack (10) for preventing inadvertent delamination of the electronic stack (10) during a product lifetime of the electronic stack (10), wherein the electronic stack (10) comprises an edge layer (15) formed of a trigger-sensitive edge material (M15) extending over an edge area (Ae) between an edge (14e) of the delamination layer (14) and an edge (10e) of the electronic stack (10).

14. A system (100) for dismantling the electronic stack (10) according to the preceding claim, the system (100) comprising
a trigger applicator (101) configured to apply a trigger (T) to the edge layer (15) of the electronic stack (10) to cause degradation of the trigger-sensitive edge material (M15) and form an exposed flap (16); and
a separator (102) configured to grip (G) the exposed flap (16) to pull the first and second layers (11,12) further apart, wherein the pulling apart (P) is facilitated by the delamination layer (14) between the first and second layers (11,12).

15. The system (100) according to the preceding claims, further comprising a dissolving station (103) for dissolving (D) the delamination layer (14), thereby further facilitating the pulling apart (P) the first and second layers (11,12).
